# EUROPÄISCHE PATENTSCHRIFT

(11) **EP 3 295 509 B1**
(45) Veröffentlichungstag und Bekanntmachung des Hinweises auf die Patenterteilung: **13.03.2019**
(21) Anmeldenummer: 16721780.1
(22) Anmeldetag: 04.05.2016
(51) Int. Cl.: H01M 10/613, H01M 10/625, H01M 10/6556, H01M 10/6566, H01M 10/6568, H01M 2/10

(54) **ENERGIESPEICHER EINES KRAFTFAHRZEUGS**
ENERGY STORE FOR A MOTOR VEHICLE
ACCUMULATEUR D'ÉNERGIE D'UN VÉHICULE AUTOMOBILE

(30) Priorität: 15.05.2015 DE 102015208999
(43) Veröffentlichungstag der Anmeldung: 21.03.2018
(73) Patentinhaber: Mahle International GmbH, 70376 Stuttgart (DE)
(72) Erfinder: MOSER, Michael, 73479 Ellwangen (DE); WEINMANN, Dominique, 72108 Rottenburg (DE)
(74) Vertreter: BRP Renaud & Partner mbB Rechtsanwälte Patentanwälte Steuerberater
(86) Internationale Anmeldenummer: PCT/EP2016/059987
(87) Internationale Veröffentlichungsnummer: WO 2016/184687

(56) Entgegenhaltungen:
- EP-A2- 0 623 798
- WO-A1-2013/021037
- CN-A- 102 305 560
- DE-A1-102011 084 000
- DE-A1-102012 103 128
- DE-A1-102012 218 102
- US-A1- 2010 104 927
- US-B1- 6 354 002

## Beschreibung

Die vorliegende Erfindung betrifft einen Energiespeicher eines Kraftfahrzeugs mit zumindest einer Batteriezelle gemäß dem Oberbegriff des Anspruchs 1. Die Erfindung betrifft außerdem eine Fluidkanaleinrichtung für einen solchen Energiespeicher sowie ein Verfahren zur Herstellung eines solchen Fluidspeichers und eines solchen Energiespeichers.

In modernen Hybrid- und Elektrofahrzeugen kommen zunehmend Hochleistungsenergiespeicher zum Einsatz, welche bezüglich einer optimalen Funktion aktiv temperiert werden müssen. Besonders eine Kühlung dieser Batteriezellen ist dabei für eine Leistungsoptimierung besonders wichtig. Aktuell werden hierzu beispielsweise fluiddurchströmte Kühlplatten verwendet, welche zusätzlich über eine Heizfunktion verfügen und dadurch sowohl ein Kühlen als auch ein Beheizen der Batteriezellen ermöglichen. Derartige Kühlplatten müssen selbstverständlich elektrisch gegenüber den Batteriezellen und/oder einem Gehäuse isoliert sein und zudem über eine ausreichende Diffusionsdichtheit verfügen.

Aus der DE 10 2012 218 102 A1 ist ein gattungsgemäßer Energiespeicher eines Kraftfahrzeugs mit einem Gehäuse und zumindest einer darin angeordneten Batteriezelle bekannt, wobei zwischen dem Gehäuse und der zumindest einen Batteriezelle ein Fluidkanal zum Temperieren der Batteriezelle angeordnet ist. Eine elektrische Schnittstelle der zumindest einen Batteriezelle liegt dabei außerhalb des Fluidkanals.

Aus der DE 10 2011 077 838 A1 ist ein Wärmeübertrager mit einem Rohrblock mit einer Mehrzahl von im Wesentlichen parallel ausgerichteten Rohren zur Führung eines Temperierungsfluids bekannt, wobei zumindest die Enden der Rohre miteinander verbunden sind. Ferner umfasst der Wärmeübertrager zumindest einen Sammelkasten, der zur Aufnahme eines Temperierungsfluides aus den Rohren ausgebildet ist, wobei der zumindest eine Sammelkasten im Inneren eine Höhe aufweist, die innerhalb eines Toleranzbereichs der Höhe der Enden der Rohre entspricht.

Aus der DE 10 2011 079 091 A1 ist ein Sammler für ein Kühlfluid mit einem Boden bekannt. Der Boden weist eine Schnittstelle zum Verbinden einer Kammer des Sammlers mit zumindest einem Kühlrohr sowie eine Öffnung auf, die sich zumindest über einen Teilbereich der Kammer erstreckt. Der Sammler weist ferner einen Deckel auf, der dazu ausgebildet ist, die Öffnung des Bodens fluiddicht zu verschließen. Der Deckel selbst ist dabei als Draht oder Extrusionsprofil ausgebildet.

Aus der EP 2 744 034 A1 ist ein weiterer Wärmeübertrager bekannt.

Nachteilig bei den aus dem Stand der Technik bekannten und zu temperierenden Energiespeichern ist deren vergleichsweise aufwändige und teure Herstellungsweise sowie eine nicht immer bedarfsgerechte Kühlung bzw. Temperierung des Energiespeichers.

Dieses Problem wird erfindungsgemäß durch den Gegenstand des unabhängigen Anspruchs 1 gelöst. Vorteilhafte Ausführungsformen sind Gegenstand der abhängigen Ansprüche.

Die vorliegende Erfindung beruht auf dem allgemeinen Gedanken, einen Energiespeicher mit einer speziell und insbesondere separat hergestellten Fluidkanaleinrichtung zu versehen, die einerseits kostengünstig herstellbar ist und die andererseits zudem eine optimierte Temperierung des Energiespeichers und damit eine optimale Leistung desselben ermöglicht. Der erfindungsgemäße Energiespeicher, welcher beispielsweise in einem Kraftfahrzeug eingesetzt werden kann, weist zumindest eine, insbesondere in einem Gehäuse angeordnete, Batteriezelle auf, üblicherweise mehrere Batteriezellen, wobei vorzugsweise zwischen dem Gehäuse und der zumindest einen Batteriezelle ein Fluidkanal zum Temperieren der Batteriezelle angeordnet ist. Dabei ist selbstverständlich klar, dass es sich bei dem Gehäuse nicht um ein Gehäuse im klassischen Sinne handeln muss, sondern der Energiespeicher auch anders verbaut werden kann, so dass das Gehäuse nicht zum Energiespeicher gehört, sondern beispielsweise ein anderes Bauteil darstellt. Dieser Fluidkanal wird nun erfindungsgemäß durch eine Fluidkanaleinrichtung gebildet, welche zwei Wände und dazwischen angeordnete Abstandshalter aufweist. Dies ermöglicht es, die Fluidkanaleinrichtung im Gegensatz zu aus dem Stand der Technik bekannten Fluidkanälen komplett separat vorzufertigen, insbesondere als kostengünstiges Verbundbauteil, wobei es darüber hinaus möglich ist, die Abstandshalter in der Fluidkanaleinrichtung derart anzuordnen, dass ein in der Fluidkanaleinrichtung strömendes Temperierungsfluid eine optimale Temperierung, insbesondere eine optimale Kühlung, der Batteriezellen ermöglicht. Wo genau die einzelnen Abstandshalter zwischen den beiden Wänden der Fluidkanaleinrichtung angeordnet werden müssen, kann zuvor durch eine Temperaturerfassung der einzelnen Batteriezellen im Betriebszustand exakt ermittelt werden. Mit der erfindungsgemäßen Fluidkanaleinrichtung und darüber auch mit dem erfindungsgemäßen Energiespeicher ist es somit möglich, diesen im Vergleich zu aus dem Stand der Technik bekannten Energiespeichern deutlich kostengünstiger auszubilden und zugleich dessen Leistungsfähigkeit durch die optimierte Temperierung, insbesondere die optimierte Kühlung, zu erhöhen.

Bei einer vorteilhaften Weiterbildung der erfindungsgemäßen Lösung sind/ist zumindest eine Wand und/oder zumindest ein Abstandshalter aus einem elektrisch isolierenden Material, insbesondere aus einem thermoplastischen Kunststoff, ausgebildet. Hierdurch eröffnet sich nicht nur die Möglichkeit, eine elektrische Isolierung zwischen den Batteriezellen und einem beispielsweise aus Metall ausgebildeten Gehäuse herzustellen, sondern ein derart thermoplastischer Kunststoff kann auch vergleichsweise einfach und kostengünstig hergestellt und verarbeitet werden.
Bei einer weiteren vorteilhaften Ausführungsform der erfindungsgemäßen Lösung ist zumindest ein Abstandshalter als Rohrstück oder als Buchse ausgebildet. In diesem Fall besäße der zumindest eine Abstandshalter eine runde Außenkontur und damit eine strömungsgünstige Außenkontur, wobei selbstverständlich alternativ auch vorstellbar ist, dass der zumindest eine Abstandshalter eine unrunde Außenkontur, insbesondere eine ovale oder eckige Außenkontur, aufweist, Denkbar ist hierbei beispielsweise auch eine im Querschnitt in der Art eines Tragflächenprofils ausgebildete Außenkontur, wodurch eine Strömungsleitung erreicht werden kann.

Erfindungsgemäß ist zumindest eine Wand der Fluidkanaleinrichtung aus einem Organoblech ausgebildet und mit den Abstandshaltern verbunden, insbesondere verklebt oder verschweißt. Eine insbesondere mit zwei aus Folie hergestellten Wänden ausgebildete Fluidkanaleinrichtung ermöglicht dabei eine vergleichsweise einfache Fertigung, insbesondere sofern die Folien mittels eines thermischen Fügeverfahrens mit den dazwischen angeordneten Abstandshaltern verschweißt werden, und zugleich bietet eine derartige Fluidkanaleinrichtung eine vergleichsweise hohe Flexibilität hinsichtlich einer Anpassung an eine Außenkontur der Batteriezellen und/oder an eine Innenkontur des Gehäuses.

Erfindungsgemäß sind die Abstandshalter derart angeordnet bzw. deren Außenkontur derart ausgebildet, dass ein Kühlmittelstrom direkt zu einem sogenannten Hot Spot zumindest einer Batteriezelle geleitet wird. Insbesondere bei Hybrid- oder Elektrofahrzeugen kommen Hochleistungsbatterien zum Einsatz, die zur Entfaltung ihrer vollen Leistungsfähigkeit optimal temperiert werden müssen. Unter die optimale Temperierung fällt insbesondere auch eine bedarfsgerechte und lokal unterschiedliche Kühlung der einzelnen Batteriezellen, so dass insbesondere sogenannte Hot Spots, an welchen eine Überhitzung einzelner Batteriezellen zu befürchten ist, gesondert gekühlt werden müssen. Dies ist mittels der erfindungsgemäßen Fluidkanaleinrichtung möglich, da über die spezielle Anordnung bzw. Ausrichtung der einzelnen Abstandshalter ein in der Fluidkanaleinrichtung strömender Fluidstrom (Temperierungsfluid), beispielsweise Kühlmittel, definiert zu entsprechenden besonders zu kühlenden Stellen, das heißt beispielsweise zu sogenannten Hot Spots, geleitet werden kann.
Bei einer weiteren vorteilhaften Ausführungsform der erfindungsgemäßen Lösung ist die Fluidkanaleinrichtung wärmeübertragend mit zumindest einer Batteriezelle verbunden, insbesondere beispielsweise mit dieser verklebt oder über eine Wärmeleitpaste verbunden. Hierdurch sollen ein optimaler Wärmeübertrag und damit auch eine optimale Temperierung der zumindest einen Batteriezelle ermöglicht werden können.
Zweckmäßig sind mehrere Abstandshalter indirektem Kontakt zueinander angeordnet und bilden dadurch eine Strömungsleitkontur. Neben einer singulären, das heißt einzelnen Anordnung einzelner Abstandshalter, ist zusätzlich oder alternativ auch eine Aneinanderreihung bzw. ein Aneinanderfügen mehrerer Abstandshalter denkbar, wodurch nicht nur Strömungsleitkonturen, sondern darüber hinaus selbst Strömungsleitpfade in der Fluidkanaleinrichtung problemlos geschaffen werden können.

Die vorliegende Erfindung beruht weiter auf dem allgemeinen Gedanken, eine Fluidkanaleinrichtung für einen zuvor beschriebenen Energiespeicher herzustellen bzw. anzubieten, der zwei Wände und dazwischen angeordnete Abstandshalter aufweist, wobei zumindest eine Wand aus Folie, insbesondere aus Kunststofffolie oder aus Kunststoffverbundfolie, aus Organoblech oder aus einer Kunststoffplatte ausgebildet mit den Abstandshaltern verbunden, insbesondere verklebt oder verschweißt, ist. Eine derartige Fluidkanaleinrichtung kann dabei durch das vorherige Ermitteln einer Temperaturverteilung an den Batteriezellen eines Energiespeichers hinsichtlich der Positionen der Abstandshalter optimal konfiguriert und aufgrund der separaten Herstellungsmöglichkeit auch qualitativ höchstwertig gefertigt werden.

Die vorliegende Erfindung beruht weiter auf dem allgemeinen Gedanken, ein Verfahren zur Herstellung der zuvor genannten Fluidkanaleinrichtung anzugeben, bei dem zunächst eine Temperaturverteilung zumindest einer Batteriezelle, vorzugsweise sämtlicher Batteriezellen, eines Energiespeichers bei unterschiedlichen Betriebszuständen ermittelt wird. Hierdurch sollen insbesondere besonders zu temperierende Stellen, wie beispielsweise Hot Spots, an denen ein schneller kritischer Temperaturanstieg zu befürchten ist, aufgefunden werden. Anschließend wird eine die ermittelte Temperaturverteilung optimal temperierende Fluidströmung, beispielsweise Kühlmittelströmung, in einer Fluidkanaleinrichtung berechnet. Bei dieser Berechnung werden somit die sogenannten Hot Spots berücksichtigt und mit einem erhöhten Kühlmittelstrom bedacht. Aus dieser berechneten Fluidströmung kann anschließend eine Schablone zur Anordnung der Abstandshalter bzw. auch zur Ausbildung der Abstandshalter, insbesondere hinsichtlich ihrer Außenkontur, erzeugt werden. Mittels dieser Schablone werden nun die Abstandshalter auf einer ersten Wand der Fluidkanaleinrichtung positioniert, wobei die erste Wand beispielsweise eine Folie oder eine Platte aus Kunststoff insbesondere einem thermoplastischen Kunststoff, oder einem Organoblech, ausgebildet sein kann. Wichtig ist dabei lediglich, dass zumindest eine der Wände elektrisch nicht leitend ist, so dass die gesamte Fluidkanaleinrichtung als elektrischer Isolator zwischen den Batteriezellen und beispielsweise dem Gehäuse fungieren kann. Durch die mittels der Schablone festgelegte Position der einzelnen Abstandshalter können diese exakt auf der ersten Wand positioniert und beispielsweise gleich mit dieser verbunden, insbesondere mit dieser verschweißt oder verklebt werden. Anschließend wird die Schablone entfernt und eine zweite Wand auf die Abstandshalter aufgelegt, wobei dann nur noch die zweite Wand oder aber beide Wände mit den Abstandshaltern verbunden, insbesondere verklebt oder verschweißt, werden. Mittels einer derartigen Schablone können nun für solche Energiespeicher optimierte Fluidkanaleinrichtungen rationell hergestellt werden.

Die nach dem im vorherigen Absatz beschriebenen Verfahren hergestellte Fluidkanaleinrichtung muss nun lediglich noch in das ggf. vorhandene Gehäuse des Energiespeichers eingelegt und anschließend die Batteriezellen eingesetzt werden. Über entsprechende Anschlüsse wird die Fluidkanaleinrichtung mit einem Temperierungsfluid, beispielsweise einem Kühlmittel, verbunden.

Weitere wichtige Merkmale und Vorteile der Erfindung ergeben sich aus den Unteransprüchen, aus den Zeichnungen und aus der zugehörigen Figurenbeschreibung anhand der Zeichnungen.

Bevorzugte Ausführungsbeispiele der Erfindung sind in den Zeichnungen dargestellt und werden in der nachfolgenden Beschreibung näher erläutert, wobei sich gleiche Bezugszeichen auf gleiche oder ähnliche oder funktional gleiche Bauteile beziehen.
Dabei zeigen, jeweils schematisch,
- Fig. 1: eine Schnittdarstellung durch einen erfindungsgemäßen Energiespeicher,
- Fig. 2: eine teilweise geschnittene Ansicht durch eine erfindungsgemäße Fluidkanaleinrichtung,
- Fig. 3: eine Schnittdarstellung durch die erfindungsgemäße Fluidkanaleinrichtung.

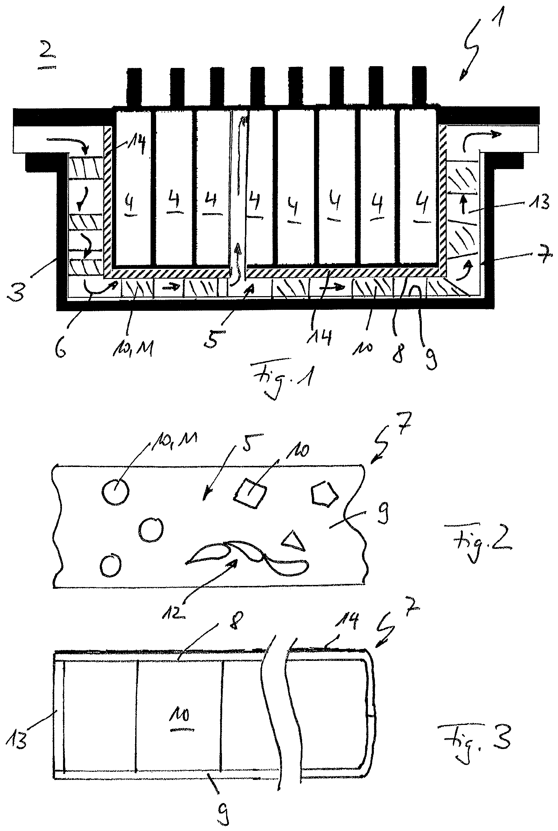

Entsprechend der Fig. 1, weist ein erfindungsgemäßer Energiespeicher 1 eines im Übrigen lediglich schematisch dargestellten Kraftfahrzeuges 2 im gezeichneten Fall ein Gehäuse 3 sowie mehrere darin angeordnete Batteriezellen 4 auf. Der Energiespeicher 1 ist dabei als wieder aufladbarer Energiespeicher ausgebildet und kann beispielsweise in einem Hybrid- oder Elektrofahrzeug eingesetzt werden. Zwischen dem Gehäuse 3 und den Batteriezellen 2 ist dabei ein Fluidkanal 5 angeordnet, durch welchen ein Temperierungsfluid 6, beispielsweise ein Kühlmittel, zum Temperieren der Batteriezellen 4 geleitet wird. Erfindungsgemäß ist nun der Fluidkanal 5 durch eine Fluidkanaleinrichtung 7 (vergleiche auch die Figuren 2 und 3) gebildet, welche zwei Wände 8, 9 und dazwischen angeordnete Abstandshalter 10 aufweist. Darüber hinaus sind die Abstandshalter 10 derart angeordnet bzw. ausgerichtet, dass eine bedarfsgerechte Temperierung, insbesondere eine bedarfsgerechte Kühlung, der Batteriezellen 4 erreicht werden kann. Dies ist insbesondere zur Leistungssteigerung des Energiespeichers von großem Vorteil, da beispielsweise sogenannte lokal auftretende Hot Spots bedarfsgerecht gekühlt werden können.

Zumindest eine der Wände 8, 9 und/oder zumindest ein Abstandshalter 10 ist dabei aus einem elektrisch isolierenden Material, beispielsweise aus einem thermoplastischen Kunststoff, ausgebildet. Die Abstandshalter 10 selbst können dabei beispielsweise als Rohrstücke oder als Buchsen 11 (vergleiche auch die Figuren 2 und 3) ausgebildet sein und damit von einem Rohr über ein entsprechendes Ablängen hergestellt werden. Alternativ hierzu können die Abstandshalter 10 selbstverständlich auch eine unrunde Außenkontur, insbesondere eine ovale oder eine eckige Außenkontur, aufweisen, wie dies beispielsweise bei den Abstandshaltern 10 gemäß der Fig. 2 dargestellt ist. Sind die Abstandshalter 10 als Rohrstücke bzw. als Buchsen 11 ausgebildet, so besitzen diese üblicherweise eine runde Außenkontur. Über die jeweils gewählte Außenkontur und/oder die Anordnung der Abstandshalter 10 kann eine besonders zielgerichtete Strömungsführung des Temperierungsfluides 6 und damit eine besonders bedarfsgerechte Temperierung der einzelnen Batteriezellen 4 erreicht werden. Gemäß der Fig. 1 ist dabei der Fluidkanal 5 lediglich zwischen dem Gehäuse 3 und den Batteriezellen 4 angeordnet, wobei selbstverständlich zusätzlich weitere, nicht graphisch dargestellte Fluidkanäle zwischen den einzelnen Batteriezellen 4 vorgesehen werden können. Auch kann selbstverständlich das Gehäuse 3 entfallen, sodass nur die Fluidkanaleinrichtung 7 die Batteriezellen 4 umgibt.

Um die Fluidkanaleinrichtung 7 kostengünstig und fertigungstechnisch einfach herstellen zu können, ist zumindest eine Wand 8, 9 aus Folie, insbesondere aus Kunststofffolie oder aus einer Kunststoffverbundfolie, aus einem Organoblech oder aus einer Kunststoffplatte ausgebildet und mit den Abstandshaltern 10, 11 verbunden, insbesondere verschweißt oder verklebt. Darüber hinaus können auch mehrere Abstandshalter 10 in direktem Kontakt zueinander angeordnet sein, und dadurch eine Strömungsleitkontur 12 bilden (vergleiche Fig. 2).

Betrachtet man noch die Fig. 3, so kann man erkennen, dass die beiden Wände 8, 9 randseitig direkt (rechte Seite) oder indirekt über ein Randelement 13 (linke Seite) dicht miteinander verbunden sind. Um einen wärmeübertragenden Kontakt zwischen der Fluidkanaleinrichtung 7 und den Batteriezellen 4 steigern zu können, kann diese beispielsweise mittels einer Wärmeleitpaste 14 (vergleiche Fig. 1) mit den Batteriezellen 4 verbunden sein.

Von großem Vorteil bei dem erfindungsgemäßen Energiespeicher 1 ist, dass dieser ein variables Strömungsfeld aufweist, kostengünstig hergestellt werden kann und eine besonders große Gestaltungsfreiheit und Anpassungsmöglichkeit an einem Verwendungszweck und Bauraum besitzt. Darüber hinaus besitzt die erfindungsgemäße Fluidkanaleinrichtung 7 eine integrierte Barriereschicht und ist durch die Verwendung von Kunststoff als elektrischer Isolator zwischen den Batteriezellen 4 und dem Gehäuse 3 ausgebildet, so dass prinzipiell auch ein metallisches Gehäuse 3 zum Einsatz kommen kann.

Herstellt wird die erfindungsgemäße Fluidkanaleinrichtung 7 gemäß dem nachfolgend beschriebenen erfindungsgemäßen Verfahren. Zunächst wird eine Temperaturverteilung zumindest einer Batteriezelle 4, vorzugsweise sämtlicher Batteriezellen 4 des Energiespeichers 1 bei unterschiedlichen Betriebszuständen ermittelt. Anschließend wird eine die ermittelte Temperaturverteilung optimal temperierende Fluidströmung in einer vorzugsweise zwischen den zu temperierenden Batteriezellen 4 und dem Gehäuse 3 angeordneten Fluidkanaleinrichtung 7 berechnet. Aus dieser berechneten Fluidströmung wird eine Schablone zur Anordnung und Ausbildung der einzelnen Abstandshalter 10 erzeugt. Mittels dieser erzeugten Schablone werden nun die entsprechenden Abstandshalter 10 auf der ersten Wand 9 der Fluidkanaleinrichtung 7 positioniert und beispielsweise bereits fixiert, insbesondere über eine Verklebung oder eine Verschweißung. Anschließend wird die Schablone entfernt und die zweite Wand 8 auf die vorpositionierten Abstandshalter 10 aufgelegt, wobei anschließend die zweite Wand 8 mit den Abstandshaltern 10 verbunden, beispielsweise verklebt oder verschweißt, wird. Selbstverständlich kann ein Verbinden der beiden Wände 8, 9 mit den Abstandshaltern 10 auch in einem einzigen Arbeitsschritt, das heißt nach dem Abziehen der Schablone und nach dem Auflegen der zweiten Wand 8 erfolgen.

Eine derart hergestellte Fluidkanaleinrichtung 7 kann anschließend in das Gehäuse 3 eingelegt und dann die Batteriezellen 4 eingesetzt werden, wobei nun über die erfindungsgemäße Fluidkanaleinrichtung 7 eine bedarfsgerechte Temperierung, insbesondere eine bedarfsgerechte Kühlung der einzelnen Batteriezellen 4 erreicht werden kann.

Mit der erfindungsgemäßen Fluidkanaleinrichtung 7 und dem damit ausgestatteten Energiespeicher 1 kann eine kostengünstige und optimierte, insbesondere im Hinblick auf sogenannte Hot Spots lokale, bedarfsgerechte Temperierung des Energiespeichers 1 erreicht werden, wodurch dessen Leistungsfähigkeit gesteigert werden kann.

## Patentansprüche

1. Energiespeicher (1) eines Kraftfahrzeugs (2) mit zumindest einer Batteriezelle (4), wobei ein Fluidkanal (5) für ein Temperierungsfluid (6) zum Temperieren der zumindest einen Batteriezelle (4) vorgesehen ist,
**dadurch gekennzeichnet,**
- **dass** der Fluidkanal (5) durch eine Fluidkanaleinrichtung (7) gebildet ist, welche zwei Wände (8,9) und dazwischen angeordnete Abstandshalter (10) aufweist, wobei die Abstandshalter (10) derart angeordnet/ausgerichtet/ausgebildet sind, dass eine bedarfsgerechte Temperierung der Batteriezellen (4) möglich ist, wobei die Abstandshalter (10) derart angeordnet sind, wobei ein Kühlmittelstrom direkt zu einem sogenannten Hot Spot zumindest einer Batteriezelle (4) geleitet wird,
- **dass** zumindest eine Wand (8,9) aus Organoblech ausgebildet und mit den Abstandshaltern (10) verbunden, insbesondere verklebt oder verschweißt, ist.

2. Energiespeicher nach Anspruch 1,
**dadurch gekennzeichnet,**
**dass** zumindest eine Wand (8,9) und/oder zumindest ein Abstandshalter (10) aus einem elektrisch isolierenden Material ausgebildet sind/ist.

3. Energiespeicher nach Anspruch 1 oder 2,
**dadurch gekennzeichnet,**
**dass** zumindest ein Abstandshalter (10) als Rohrstück oder als Buchse (11) ausgebildet ist.

4. Energiespeicher nach einem der vorhergehenden Ansprüche,
**dadurch gekennzeichnet,**
**dass** zumindest ein Abstandshalter (10) eine unrunde Außenkontur, eine ovale oder eckige Außenkontur aufweist.

5. Energiespeicher nach einem der Ansprüche 1 bis 4,
**dadurch gekennzeichnet,**
**dass** mehrere Abstandshalter (10) in direktem Kontakt zueinander angeordnet sind und eine Strömungsleitkontur (12) bilden.

6. Energiespeicher nach einem der vorhergehenden Ansprüche,
**dadurch gekennzeichnet,**
**dass** die beiden Wände (8,9) randseitig direkt oder indirekt über ein Randelement (13) dicht miteinander verbunden sind.

7. Fluidkanaleinrichtung (7) eines Energiespeichers (1) nach einem der Ansprüche 1 bis 6, der zwei Wände (8,9) und dazwischen angeordnete Abstandshalter (10) aufweist, wobei dass zumindest eine Wand (8,9) aus Organoblech ausgebildet ist und mit den Abstandshaltern (10) verbunden, insbesondere verklebt oder verschweißt, ist.

8. Verfahren zur Herstellung einer Fluidkanaleinrichtung (7) nach Anspruch 7, bei dem
- eine Temperaturverteilung der zumindest einen Batteriezelle (4), vorzugsweise sämtlicher Batteriezellen (4), des Energiespeichers (1) bei unterschiedlichen Betriebszuständen ermittelt wird,
- eine die ermittelte Temperaturverteilung optimal temperierende Fluidströmung in der Fluidkanaleinrichtung (7) berechnet wird,
- aus der berechneten Fluidströmung eine Schablone zur Anordnung der Abstandshalter (10) erzeugt wird,
- die Abstandshalter (10) mittels der Schablone ausgerichtet auf einer ersten Wand (9) der Fluidkanaleinrichtung (7) positioniert optional fixiert werden,
- die Schablone entfernt und eine zweite Wand (8) auf die Abstandshalter (10) aufgelegt wird,
- die zumindest die Wand (8) mit den Abstandshaltern (10) verbunden, insbesondere verklebt oder verschweißt, werden.

9. Verfahren zur Herstellung eines Energiespeichers (1) nach einem der Ansprüche 1 bis 6, bei dem die gemäß dem Verfahren nach Anspruch 8 hergestellte Fluidkanaleinrichtung (7) und zumindest eine Batteriezelle (4) in ein Gehäuse (3) eingelegt werden, derart, dass die Fluidkanaleinrichtung (7) mit ihren Abstandshaltern (10) so zur zumindest einen Batteriezelle (4) ausgerichtet ist, dass die zuvor berechnete, optimal temperierende Fluidströmung erreicht wird.

## Claims

1. Energy store (1) of a motor vehicle (2) comprising at least one battery cell (4), wherein a fluid channel (5) for a temperature control fluid (6) is provided to control the temperature of said at least one battery cell (4), **characterised in that**
- the fluid channel (5) is formed by a fluid channel device (7) that has two walls (8, 9), and spacers (10) arranged between these, said spacers (10) being arranged/aligned/designed to allow needs-based temperature control of the battery cells (4), wherein the spacers (10) are so arranged, wherein a coolant flow is conducted directly to a so-called "hot spot" of at least one battery cell (4),
- at least one wall (8, 9) comprises an organic sheet and is connected, more particularly glued or welded, to the spacers (10).

2. Energy store according to claim 1, **characterised in that** at least one wall (8, 9) and/or at least one spacer (10) comprise(s) an electrically insulating material.

3. Energy store according to claim 1 or 2, **characterised in that** at least one spacer (10) is designed as tube section or as bushing (11).

4. Energy store according to any one of the preceding claims, **characterised in that** at least one spacer (10) has a non-round outer contour, an oval or angled outer contour.

5. Energy store according to any one of claims 1 to 4, **characterised in that** a plurality of spacers (10) are arranged in direct contact to one another and define a flow-guiding contour (12).

6. Energy store according to any one of the preceding claims, **characterised in that** the two walls (8,9) are closely connected to one another on an edge side directly or indirectly via an edging element (13).

7. Fluid channel arrangement (7) of an energy store (1) according to any one of claims 1 to 6, comprising two walls (8, 9) and spacers (10) arranged therebetween, wherein at least one wall (8, 9) comprises organic sheet and is connected, more particularly glued or welded, to the spacers (10).

8. Method for producing a fluid channel arrangement (7) according to claim 7, in which
- a temperature distribution of the at least one battery cell (4), preferably of all battery cells (4), of the energy store (1) is determined in different operating states,
- a fluid flow, optimally controlling a temperature of the determined temperature distribution, is calculated in the fluid channel arrangement (7),
- a template for the arrangement of the spacers (10) is produced from the calculated fluid flow,
- the spacers (10), aligned by means of the template, are positioned, and optionally secured, on a first wall (9) of the fluid channel arrangement (7),
- the template is removed and a second wall (8) is applied onto the spacers (10),
- at least the wall (8) is connected, more particularly glued or welded, to the spacers (10).

9. Method for producing an energy store (1) according to any one of claims 1 to 6, in which the fluid channel arrangement (7) produced according to the method according to claim 8 and at least one battery cell (4) are inserted into a housing (3), such that the fluid channel arrangement (7) is aligned with its spacers (10) to the at least one battery cell (4), so that the previously calculated, optimally temperature-controlling fluid flow is achieved.

## Revendications

1. Accumulateur d'énergie (1) d'un véhicule automobile (2) avec au moins une cellule de batterie (4), dans lequel un canal de fluide (5) destiné à un fluide de mise à température (6) est prévu pour tempérer l'au moins une cellule de batterie (4),
**caractérisé en ce que**
- le canal de fluide (5) est formé par un dispositif de canal de fluide (7) qui comporte deux parois (8, 9) et des écarteurs (10) agencés entre celles-ci, lesquels écarteurs (10) sont agencés/orientés/réalisés de telle sorte qu'une mise à température des cellules de batterie (4) adaptée aux besoins est possible et lesquels écarteurs (10) sont agencés de telle sorte qu'un flux d'agent de refroidissement est conduit directement à un point chaud dit Hot Spot d'au moins une cellule de batterie (4),
- au moins une paroi (8, 9) est réalisée en tôle organique et est reliée aux écarteurs (10), en particulier collée ou soudée à ceux-ci.

2. Accumulateur d'énergie selon la revendication 1,
**caractérisé en ce**
**qu'**au moins une paroi (8, 9) et/ou au moins un écarteur (10) sont/est réalisés/réalisé en un matériau électriquement isolant.

3. Accumulateur d'énergie selon la revendication 1 ou 2,
**caractérisé en ce**
**qu'**au moins un écarteur (10) est réalisé sous forme de pièce tubulaire ou de douille (11).

4. Accumulateur d'énergie selon l'une quelconque des revendications précédentes,
**caractérisé en ce**
**qu'**au moins un écarteur (10) a un contour extérieur en faux-rond, un contour extérieur ovale ou polygonal.

5. Accumulateur d'énergie selon l'une quelconque des revendications 1 à 4,
**caractérisé en ce**
**que** plusieurs écarteurs (10) sont agencés en contact direct les uns avec les autres et forment un contour (12) servant de guide de flux.

6. Accumulateur d'énergie selon l'une quelconque des revendications précédentes,
**caractérisé en ce**
**que** les deux parois (8, 9) sont reliées l'une à l'autre de manière étanche, par leurs bords, directement ou indirectement par l'intermédiaire d'un élément de bord (13).

7. Dispositif de canal de fluide (7) d'un accumulateur d'énergie (1) selon l'une quelconque des revendications 1 à 6, qui comporte deux parois (8, 9) et des écarteurs (10) agencés entre celles-ci, dans lequel au moins une paroi (8, 9) est réalisée en tôle organique et est reliée aux écarteurs (10), en particulier collée ou soudée à ceux-ci.

8. Procédé de fabrication d'un dispositif de canal de fluide (7) selon la revendication 7, dans lequel
- une distribution de température de l'au moins une cellule de batterie (4), de préférence de toutes les cellules de batterie (4), de l'accumulateur d'énergie (1) est déterminée pour différents états de fonctionnement,
- un flux de fluide tempérant de manière optimale la distribution de température déterminée dans le dispositif de canal de fluide (7) est calculé,
- à partir du flux de fluide calculé, un modèle est produit pour agencer les écarteurs (10),
- les écarteurs (10) sont fixés optionnellement positionnés de manière orientée au moyen du modèle sur une première paroi (9) du dispositif de canal de fluide (7),
- le modèle est retiré et une deuxième paroi (8) est posée sur les écarteurs (10),
- au moins la paroi (8) est reliée aux écarteurs (10), en particulier collée ou soudée.

9. Procédé de fabrication d'un accumulateur d'énergie (1) selon l'une quelconque des revendications 1 à 6, dans lequel le dispositif de canal de fluide (7) fabriqué selon le procédé selon la revendication 8 et au moins une cellule de batterie (4) sont placés dans un boîtier (3) de telle sorte que le dispositif de canal de fluide (7) est orienté de telle manière avec ses écarteurs (10) par rapport à l'au moins une cellule de batterie (4) que le flux de fluide tempéré de manière optimale calculé préalablement est obtenu.
